# EUROPÄISCHE PATENTSCHRIFT

(11) **EP 3 216 106 B1**
(45) Veröffentlichungstag und Bekanntmachung des Hinweises auf die Patenterteilung: **15.07.2020**
(21) Anmeldenummer: 15781344.5
(22) Anmeldetag: 15.10.2015
(51) Int. Cl.: H02J 13/00, G06F 17/18, G06Q 10/06, H04H 60/73

(54) **VERFAHREN ZUR DATENANREICHERUNG VON MESSDATENSÄTZEN EINES NIEDERSPANNUNGSNETZES**
METHOD FOR ENRICHING DATA IN MEASUREMENT DATA RECORDS OF A LOW-VOLTAGE NETWORK
PROCÉDÉ D'ENRICHISSEMENT D'ENREGISTREMENTS DE MESURE D'UN RÉSEAU BASSE TENSION

(30) Priorität: 06.11.2014 DE 102014222662
(43) Veröffentlichungstag der Anmeldung: 13.09.2017
(73) Patentinhaber: Siemens Aktiengesellschaft Österreich, 1210 Wien (AT)
(72) Erfinder: BARSUKOV, Yaroslav, A-1020 Wien (AT); MOSSHAMMER, Ralf, A-1020 Wien (AT)
(74) Vertreter: Maier, Daniel Oliver
(86) Internationale Anmeldenummer: PCT/EP2015/073832
(87) Internationale Veröffentlichungsnummer: WO 2016/071087

(56) Entgegenhaltungen:
- WO-A1-2008/092513
- WO-A1-2013/149899
- DE-A1-102013 206 946
- US-A1- 2014 012 524

## Beschreibung

### GEBIET DER ERFINDUNG

Die vorliegende Erfindung betrifft ein Verfahren zur Datenanreicherung von Messdatensätzen eines Niederspannungsnetzes, wobei ein Messdatensatz zumindest einen Messwert und eine strukturlose Information enthält, von welchem Netzknoten der Datensatz stammt.

Niederspannungsnetze sind ein Teil des Stromnetzes zur Verteilung der elektrischen Energie an den größten Teil der elektrischen Endverbraucher, der aus Niederspannungsgeräten besteht. Um Spannungsverluste zu vermeiden, sind Niederspannungsnetze in der räumlichen Ausdehnung auf einen Bereich von einigen 100 m bis zu einigen wenigen Kilometern beschränkt. Sie werden daher regional über Transformatorenstationen aus einem übergeordneten Mittelspannungsnetz gespeist. Sie werden in Europa üblicherweise mit einer Netzspannung von 230 V (zwischen jedem Außenleiter und dem Neutralleiter) bzw. 400 V (zwischen den drei Außenleitern), jedenfalls aber nur bis zu 1000 V betrieben. Bemessungsleistungen einzelner Ortsnetztransformatoren können je nach Zielnetzplanung des jeweiligen Verteilnetzbetreibers variieren, liegen aber typischer Weise bei 250 oder 400 kVA für ländliche Gebiete und 630 oder 800 kVA für innerstädtische Gebiete.

Der Begriff Niederspannungsnetz im Sinne dieser Erfindung bezeichnet einen Teil des Verteilernetzes, also einen Abschnitt, der von einem bestimmten Ortsnetztransformator mit elektrischer Energie versorgt wird.

Komponenten des Niederspannungsnetzes - und damit Netzknoten - können sein: Stromerzeuger (z.B. Photovoltaikanlagen, Kleinwindkraftanlagen), Speicher (z.B. Batterien, Wärmepumpen) wie Ladestationen für Elektrofahrzeuge, flexible Verbraucher (z.B. elektrische Speicherheizungen, Gebäude/Haushalte mit und ohne Gebäudeautomationssystem und entsprechenden Aktoren (= Wandler oder Antriebselemente, setzen elektrische Signale in mechanische Bewegung oder andere physikalische Größen (z. B. Druck oder Temperatur) um)) und Netzbetriebsmittel (Transformatoren, Leitungen, Sicherungen, Messgeräte wie Smart Meter, Transformator-Stufensteller, usw.).

Unter "strukturloser Information" versteht man die Tatsache, dass die Messdatensätze keine Information enthalten, welches physikalische (körperliche) Gerät der Netzknoten ist, der einen bestimmten Messdatensatz erzeugt und gesendet hat, also ob das Gerät z.B. ein Transformator, ein Verbraucher oder ein Messgerät ist. Der Messdatensatz enthält lediglich eine Adresse, z.B. eine Zahlen- oder Buchstabenkombination (wie eine Gerätenummer), die einem bestimmten Netzknoten fix zugeordnet ist, aber keine inhärente Bedeutung hat. Ebenso werden die Messwerte nur in Form von Zahlen ohne Angabe von physikalischen Einheiten übermittelt, sodass aus dem Messdatensatz an sich nicht hervorgeht, welche physikalische Größe gemessen worden ist.

Heutzutage ist der klassische Netzbetrieb durch die zunehmende Durchdringung mit dezentralen, meist erneuerbaren Energieerzeugungsanlagen (DEA) vor große Herausforderungen gestellt. Dahingehend zeigte sich in den letzten Jahren der Trend zu "Smart Grids", sogenannten intelligenten Netzen, welche als Lösung dieser steigenden Herausforderung angesehen werden. Diese intelligenten Stromnetze dienen unter anderem zur kommunikativen Vernetzung und Steuerung von Stromerzeugern, Speichern, elektrischen Verbrauchern und Netzbetriebsmitteln in Energieübertragungs- und Energieverteilungsnetzen der Elektrizitätsversorgung.

Die zunehmend von Netzbetreibern gewünschte Automatisierung des Niederspannungsnetzes erzeugt aufgrund der sehr großen Anzahl zu automatisierender Netzknoten und deren unterschiedlicher technischer Beschaffenheit eine massive Herausforderung. Die Anbindung messtechnisch interessanter Netzknoten, wie Messzähler (Smart Meter) oder Wechselrichteranlagen, an Datenzentren ist nicht nur netzwerk- und kommunikationstechnisch anspruchsvoll. Vielmehr stellen Smart Meter lediglich unstrukturierte Daten zur Verfügung. So bietet etwa das weit verbreitete Protokoll IEC 60870-5-104 nur sehr eingeschränkte Meta-Informationen des übertragenden Objekts an, wie etwa den Datentyp, nicht aber weiterführende, für eine Verarbeitung der Daten interessante Parameter wie physikalische Einheit, Art des Messsensors, geographischer Ursprung, Netzabschnitt, usw. Modernere Protokolle wie IEC 61850 bieten mitunter einen deutlich höheren Strukturierungsgrad der Daten. Durch teilweise sehr lange Lebenszyklen und hohe Kosten der übertragenden Objekte ist eine rasche Lösung der fehlenden Meta-Informationen durch Ersetzen der Objekte mit besser ausgerüsteten Objekten nicht zu erwarten.

### STAND DER TECHNIK

Die übliche Vorgehensweise zur Identifikation von Netzknoten in einem übergeordneten System (einem sogenannten Head-End System) erfolgt durch manuelle Auswertung. Ein Head-End System umfasst dabei in der Regel Hardware und Software, die von Messgeräten einer Messinfrastruktur (z.B. einer sogenannten advanced metering infrastructure (AMI)) einen Strom von Messdaten erhält. Head-End Systeme können eine beschränkte Anzahl von Datenauswertungen vornehmen, bevor sie die Daten für andere Systeme verfügbar machen. Bei der manuellen Auswertung trifft ein Ingenieur eine statische Zuordnung des Netzknotens zu einem umfassender strukturierten Element eines übergeordneten Systems. So wird etwa einer strukturlosen Adresse eine bestimmte Bedeutung, z.B. "Transformator-Stufenstellung", zugeordnet, die nun eine eindeutige Aussage über die Art des Geräts, die Einheit, welcher der Netzknoten zugeordnet ist, und die Bedeutung innerhalb des Niederspannungsnetzes trifft. Diese Vorgehensweise weist mehrere konkrete Nachteile auf:
- Der Ingenieur muss Kenntnis der internen Datenstruktur des Netzknotens, das heißt, aller Netzknoten, haben, was bei vielen Netzknoten kaum möglich ist.
- Die Zuordnung ist üblicher Weise statisch und im Betrieb des Niederspannungsnetzes nur schwer änderbar.
- Das Ausbringen neuer Netzknoten oder das Ändern bestehender Netzstrukturen ist dem Ingenieur zur Kenntnis zu bringen.

Insbesondere der letzte Punkt widerspricht der Forderung, den Übergang traditioneller Netze zu intelligenten "Smart Grids" möglichst konfigurationsfrei zu gestalten. Manuelles Engineering ist besonders im Niederspannungsnetz höchst problematisch, weil hier um Zehnerpotenzen mehr Netzknoten vorliegen als in der nächsthöheren Netzebene. US 2014/012524 A1 ist ein Beispiel des Standes der Technik.

### DARSTELLUNG DER ERFINDUNG

Es ist eine Aufgabe der Erfindung, ein Verfahren anzugeben, mit welchem die Zuordnung von Bedeutungen zu Messdaten zumindest teilweise ohne Mitarbeit von Menschen erfolgen kann, die Strukturierung der Messdaten also zumindest zum Teil konfigurationsfrei gestaltet werden kann.

Diese Aufgabe wird durch ein Verfahren nach Anspruch 1 gelöst. Es erfolgt somit eine automatische Annotation der Messdaten, ohne manuelles Engineering durch einen Ingenieur. Somit können bestehende Geräte (Netzknoten), insbesondere Messstellen und Aktoren wie regelbare Transformatoren oder Wechselrichter, in ein intelligentes Stromnetz ohne zusätzlichen Konfigurations- oder Engineeringaufwand eingebunden werden. Die Ergebnisse der automatischen Annotation werden in den meisten Fällen zwar ungenauer oder allgemeiner sein als jene des manuellen Engineerings. Allerdings ist für viele Anwendungen, etwa die Darstellung des Niederspannungsnetzes in einer Leitwarte, eine reduzierte Datenschärfe ausreichend. Die genaue Identität eines Netzknotens ist meist von untergeordnetem Interesse. Vielmehr interessiert das Verhalten des Netzknotens, z.B. einer Messstelle, etwa, ob die Spannung in einem kritischen Bereich liegt oder welcher Netzknoten üblicher Weise Probleme bei der Spannungshaltung verursacht, und die Beziehung der Netzknoten des Niederspannungsnetzes untereinander.

Wenn Messdatensätze asynchron eintreffen, heißt das, sie treffen nicht in regelmäßigen zeitlichen Abständen ein. Zudem werden die Messdatensätze unterschiedlicher Netzknoten nicht zu gleichen Zeitpunkten beim Datenspeicher eintreffen. Durch die Speicherung der Messdatensätze als zeitliche Reihe können später auf einfache Weise jene Messdaten selektiert werden, die in einem bestimmten Zeitraum angefallen sind, um sie mit den Messdaten anderer Messwertreihen für diesen Zeitraum zu vergleichen.

Die Einrichtung zur automatisierten Datenanreicherung, im Folgenden auch als Annotation Engine bezeichnet, kann innerhalb der bekannten Automatisierungsarchitektur von Niederspannungsnetzen als Erweiterung des Head-End Systems ausgeführt sein. Ein Teil der Annotation Engine ist ein Datenspeicher, der eintreffende Messdaten in Zeitreihen ablegt. Nach einer Anlaufphase, in der die Messdatensätze zunächst gesammelt werden, ist es der Annotation Engine mit steigendem Konfidenzintervall möglich, aus den Zeitreihen signifikante Informationen hauptsächlich statistische Natur zu berechnen, die eine Anreicherung der Messdatensätze ermöglichen.

Die Anreicherung der Daten erfolgt durch das Erstellen von semantischen Anmerkungen, etwa sogenannten Tags, also einfachen, beschreibenden Ausdrücken, wie sie auch in sozialen Netzwerken im Internet üblich sind. Pro Messdatensatz, also pro Messwert und pro Netzknoten, können jeweils eine beliebige Anzahl von Anmerkungen zugewiesen werden.

Es kann also vorgesehen sein, dass eine Anmerkung eine Information enthält, um welche Art von Netzknoten es sich handelt und/oder um welche Messgröße es sich beim Messwert handelt. Eine solche Information wird hier als strukturierte Information bezeichnet.

Im Folgenden werden mögliche mathematische Analysen für das erfindungsgemäße Verfahren erläutert.

Es kann vorgesehen sein, dass die mathematische Analyse eine Mittelwertbildung der Messwerte innerhalb einer zeitlichen Reihe umfasst, wobei bei einem typischen vorbekannten Mittelwert eine Anmerkung angefügt wird, dass es sich um bestimmte Art von Netzknoten und/oder Messwert handelt. Es handelt sich hierbei um eine statistische Analyse, mit welcher zur Feststellung der physikalischen Einheit des Netzknotens z.B. laufend der Mittelwert der Messwerte berechnet wird. Wenn der Mittelwert etwa "230" beträgt, wird es sich bei den Messwerten um Spannungswerte handeln und beim Netzknoten um ein Spannungsmessgerät. Die Messwerte dieser Zeitreihe können also etwa jeweils mit der Anmerkung "Spannungswert" versehen werden, der Netzknoten mit einer Anmerkung "Spannungsmessgerät".

Die mathematische Analyse kann eine Frequenzanalyse innerhalb einer zeitlichen Reihe umfassen, wobei bei Überschreitung eines typischen Zeitabstands zwischen zwei Messdatensätzen des Netzknotens eine Anmerkung angefügt wird, dass der Netzknoten ausgefallen ist. Durch ein ungewöhnlich langes Ausbleiben eines Messdatensatzes eines bestimmten Netzknotens kann für den Netzknoten eine Anmerkung erfolgen, dass dieser temporär ausgefallen ist.

Die mathematische Analyse kann eine Verhaltensanalyse innerhalb einer zeitlichen Reihe umfassen, wobei bei einer begrenzten Anzahl von immer gleichen Zahlenwerten als Messwerten des Netzknotens eine Anmerkung angefügt wird, dass es sich um einen Schalter oder Stufensteller handelt. Der Stufensteller könnte aber auch einem Transformator zugeordnet werden. Werden also von einem Netzknoten immer nur die gleichen zwei Zahlenwerte für den Messwert an den Datenspeicher übermittelt, so wird für den Netzknoten eine Anmerkung erstellt, dass dieser ein einfacher Schalter ist. Werden von einem Netzknoten immer nur die gleichen drei oder mehr Zahlenwerte für den Messwert an den Datenspeicher übermittelt, so wird für den Netzknoten eine Anmerkung erstellt, dass dieser ein Stufensteller eines Transformators ist.

Die mathematische Analyse kann eine Korrelationsanalyse zwischen mehreren zeitlichen Reihen umfassen, wobei bei aufeinanderfolgenden Änderungen der Messwerte unterschiedlicher zeitlicher Reihen bzw. Netzknoten eine Anmerkung angefügt wird, dass es sich um elektrisch voneinander abhängige Netzknoten handelt. Führt also ein Schaltvorgang eines ersten Netzknotens zu einem Spannungssprung an einem anderen Netzknoten, so erhält der andere Netzknoten die Anmerkung "elektrisch abhängig vom Netzknoten Nr.... (Adresse des ersten Netzknotens".

Auf diese Weise wird auch eine zeitliche Korrelation festgestellt werden, indem eine zeitlich versetzte Reaktion des Schaltvorgangs an mehreren anderen Netzknoten beobachtet wird. Insofern kann vorgesehen sein, dass für jenen Netzknoten, der die erste Änderung des Messwerts erfährt, eine Anmerkung erstellt wird, dass es sich um einen Stufensteller (bzw. um einen Transformator) handelt, während für die spannungsfolgenden Netzknoten mit späteren Änderungen des Messwerts eine Anmerkung erstellt wird, dass diese als Messgeräte im elektrisch gleichen Netz ausgebildet sind.

Die Korrelationsanalyse kann auch Aussagen über die örtliche Anordnung von Netzknoten liefern. Wenn man die zeitlichen Reihen der Messwerte über längere Zeit beobachtet, kann man aufgrund der zeitversetzten Reaktion auf Schaltvorgänge eine geographische Position der einzelnen Netzknoten abschätzen oder zumindest angeben, dass sie sich im gleichen Netzgebiet, also etwa im gleichen Netzstrang, befinden.

Die mathematische Analyse kann eine Ausfallsanalyse von mehreren zeitlichen Reihen umfassen, wobei bei gleichzeitigem Ausfall von mehreren Netzknoten - wenn von diesen also keine Messdatensätze einlangen - eine Anmerkung erstellt wird, dass Abtrennungsschalter für diese Netzknoten vorhanden sind.

Schließlich kann durch Datenverarbeitungsprogramme zur Erkennung von komplexen Mustern, zur Kurvenanpassung oder mit komplexen nichtlinearen Analysemethoden (etwa mit neuronalen Netzen) ein Muster oder Profil eines Messwertverlaufs (z.B. ein Spannungs- und/oder Leistungsprofil) ermittelt und ein Vergleich mit bekannten Mustern oder Profilen, wie einem Standard-Haushaltsprofil "H0", durchgeführt werden. Bei Übereinstimmung der Muster oder Profile wird dem Netzknoten eine Anmerkung angefügt, dass es sich um einen bestimmten Netzknotentyp, z.B. einen Haushalt, handelt. Insofern kann vorgesehen sein, dass die mathematische Analyse eine Mustererkennung innerhalb einer zeitlichen Reihe umfasst, wobei bei Übereinstimmung des Musters der zeitlichen Reihe des untersuchten Netzknotens mit vorbekannten Mustern, die einer bekannten Art von Netzknoten entsprechen, eine Anmerkung erstellt wird, dass der untersuchte Netzknoten von einer bestimmten bekannten Art ist.

Generell können die Anmerkungen mit einer Konfidenz oder einem Konfidenzintervall versehen werden. Pro Messdatensatz, also pro Messwert und pro Netzknoten, können ja jeweils eine beliebige Anzahl von Anmerkungen zugewiesen werden, diese Anmerkung kann also auch ein Wert zugewiesen, wie hoch die Präzision der Anmerkung ist, mit welcher Sicherheit sie also zutreffend ist.

Durch die gegenständliche Erfindung ist ja nicht ausgeschlossen, dass weiterhin auch manuelles Engineering stattfindet und manuell Anmerkungen erstellt und in die Annotation Engine übernommen werden, denen dann eine hohe, insbesondere die höchstmögliche, Konfidenz zugeteilt wird, weil sie ja von einem Ingenieur überprüft worden ist. Die manuelle Annotation wird besonders für kritische Netzknoten sinnvoll sein. Z.B. könnte manuell festgelegt werden, bei welchen Netzknoten es sich um einen Transformator, also die Wurzel des Niederspannungsnetzes, handelt. Dadurch würde sich dann die Konfidenz in das automatisch erstellte Urteil (also in die automatisch erstellte Anmerkung), dass es sich bei den anderen Netzknoten (insbesondere um elektrisch voneinander abhängige Netzknoten) wohl um Smart Meters handelt, erhöhen. Insofern kann vorgesehen sein, dass bei manueller Festlegung einer Konfidenz oder eines Konfidenzintervalls für eine Anmerkung betreffend einen Netzknoten die Konfidenz oder das Konfidenzintervall von automatisch erstellten Anmerkungen betreffend andere Netzknoten erhöht wird.

Schließlich betrifft die gegenständliche Erfindung auch ein Computerprogrammprodukt, welches ein Programm umfasst und direkt in einen Speicher eines zentralen Rechners eines Niederspannungsnetzes ladbar ist, mit Programm-Mitteln, um alle Schritte des erfindungsgemäßen Verfahrens auszuführen, wenn das Programm vom zentralen Rechner ausgeführt wird.

### KURZE BESCHREIBUNG DER FIGUREN

Zur weiteren Erläuterung der Erfindung wird im nachfolgenden Teil der Beschreibung auf die Figuren Bezug genommen, aus denen weitere vorteilhafte Einzelheiten und mögliche Einsatzgebiete der Erfindung zu entnehmen sind. Dabei zeigt
Fig. 1 eine schematische Darstellung des Verfahrensablaufes zur Datenanreicherung nach dem Stand der Technik,
Fig. 2 eine schematische Darstellung des erfindungsgemäßen Verfahrensablaufes zur Datenanreicherung.

### WEGE ZUR AUSFÜHRUNG DER ERFINDUNG

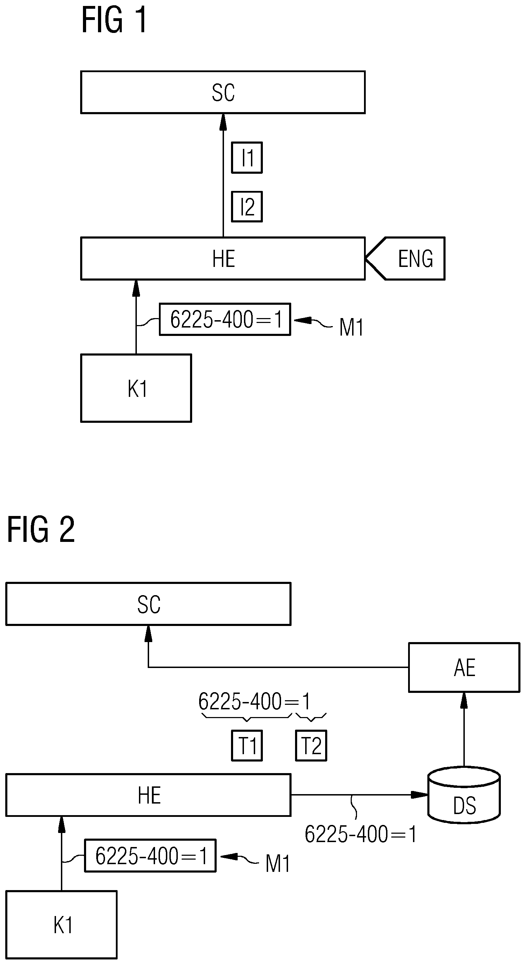

Fig. 1 zeigt überblicksmäßig einen Ablauf nach dem Stand der Technik, der auf ein Niederspannungsnetz mit hier nur einem dargestellten Netzknoten K1 angewendet wird. Dieser Netzknoten K1 sendet einen Messdatensatz M1 bestehend aus der unstrukturierten Information "6225-400=1" an das Head-End System HE, das gleichsam als "Datenkonzentrator" dient. Der Messdatensatz M1 besteht also aus einer strukturlosen Adresse "6225-400", die keine inhaltliche Bedeutung hat, und dem Messwert "1", für den ebenfalls keine Bedeutung, also keine physikalische Einheit, mitgesendet wird. Nun wird durch manuelles Eingreifen ENG eines Ingenieurs beim Head-End System HE erkannt, dass es sich bei "6225-400" um einen bestimmten Transformator, z.B. Transformator1, handelt und dass der Messwert "1" die aktuelle Stufenstellung dieses Transformators darstellt. Durch manuelles Eingreifen ENG wird nun der Messdatensatz in zwei strukturierte Informationen I1, I2 umgewandelt, Information I1 lautet "Transformator1" und Information I2 lautet "Stufenstellung = 1". Nun werden vom Head-End System HE an das übergeordnetes Steuer- und Überwachungssystem SC nur die beiden Informationen I1, I2 übermittelt, nicht jedoch der ursprüngliche Messdatensatz M1 oder die strukturlose Adresse "6225-400". Das übergeordnete Steuer- und Überwachungssystem SC wird üblicher Weise mit Supervisory Control and Data Acquisition (SCADA) bezeichnet, darunter versteht man das Überwachen und Steuern technischer Prozesse mittels eines Computer-Systems.

Auch beim erfindungsgemäßen Verfahren nach Fig. 2 sendet der Netzknoten K1 (die übrigen zahlreichen Netzknoten sind hier nicht dargestellt) einen Messdatensatz M1 bestehend aus der Information "6225-400=1" an das Head-End System HE, das wieder als "Datenkonzentrator" dient. Der Messdatensatz wird aber nun nicht manuell analysiert, sondern der Messdatensatz wird an einen Datenspeicher DS weitergeleitet, wo für jeden Netzknoten K1, also für jede unstrukturierte Adresse (z.B. für "6225-400") eine eigene Zeitreihe angelegt wird, die Messdatensätze also mit der Information über das zeitliche Eintreffen im Head-End System HE oder im Datenspeicher DS abgelegt werden. Die Daten des Datenspeichers DS werden nun der Annotation Engine AE zugeführt, welche die zeitlichen Reihen mittels automatischer Datenverarbeitung einer mathematischen Analyse unterzieht. In dargestellten Fall erkennt die Annotation Engine AE also, dass die Adresse "6225-400" bisher immer nur eine begrenzte Anzahl von niedrigen ganzzahligen positiven Werten geliefert hat, sodass der aktuelle Messwert "1" wohl eine Stufenstellung darstellt. Daraus folgt, dass der Netzknoten "6225-400" ein Transformator (bzw. dessen Stufensteller ist, wenn man diese Unterscheidung treffen möchte).

Die Annotation Engine AE erstellt somit zwei Anmerkungen oder Tags T1, T2, der erste Tag T1 enthält das Wort "Transformator" und wird im Messdatensatz M1 der Adresse "6225-400" angefügt, der zweite Tag T2 enthält das Wort "Stufenstellung" und wird im Messdatensatz M1 dem Messwert "1" angefügt.

Anschließend werden von der Annotation Engine AE der Messdatensatz M1, also "6225-400=1" gemeinsam mit den beiden Anmerkungen oder Tags T1, T2 an das übergeordnetes Steuer- und Überwachungssystem SC übermittelt und auch in der Annotation Engine AE abgespeichert wird.

### Bezugszeichenliste:

- AE: Annotation Engine
- DS: Datenspeicher
- ENG: manuelles Eingreifen
- HE: Head-End System
- I1: erste Information
- I2: zweite Information
- K1: Netzknoten;
- M1: Messdatensatz
- SC: übergeordnetes Steuer- und Überwachungssystem
- T1: erste Anmerkung
- T2: zweite Anmerkung

## Patentansprüche

1. Verfahren zur Datenanreicherung von Messdatensätzen (M1) eines Niederspannungsnetzes mit zumindest einem Netzknoten (K1) für eine Darstellung des Niederspannungsnetzes in einer Leitwarte und/oder für eine Darstellung von Beziehungen von Netzknoten im Niederspannungsnetz, wobei vom zumindest einen Netzknoten (K1) ein Messdatensatz (M1) erzeugt und an ein übergeordnetes System (HE), insbesondere Head-End-System, gesendet wird, und dieser Messdatensatz (M1) zumindest einen Messwert und eine strukturlose Information enthält, welche angibt, von welchem Netzknoten (K1) der Datensatz stammt, wobei, insbesondere asynchron, eintreffende Messdatensätze (M1), welche von mehreren Netzknoten (K1) an das übergeordnete System (HE) gesendet werden, in einem Datenspeicher (DS) in jeweils einer zeitlichen Reihe pro Netzknoten (K1) gespeichert werden, **dadurch gekennzeichnet,**
- **dass** die zeitlichen Reihen mittels automatischer Datenverarbeitung durch eine Einrichtung zur automatisierten Datenanreicherung (AE) einer mathematischen Analyse unterzogen werden, wobei die mathematische Analyse eine Mustererkennung innerhalb einer zeitlichen Reihe umfasst, und
- **dass** ein Ergebnis der Analyse in Form von zumindest einer semantischen Anmerkung (T1, T2) dem jeweiligen Messdatensatz (M1) angefügt wird, wobei bei Übereinstimmung eines Musters der zeitlichen Reihe des untersuchten Netzknotens (K1) mit vorbekannten Mustern, welche einer bekannten Art von Netzknoten entsprechen, die Anmerkung (T1, T2) mit einer Information zur Feststellung einer physikalischen Einheit des untersuchten Netzknotens (K1) erstellt wird.

2. Verfahren nach Anspruch 1, **dadurch gekennzeichnet, dass** eine Anmerkung eine Information (T2) enthält, um welche Messgröße es sich beim Messwert handelt.

3. Verfahren nach einem der Ansprüche 1 bis 2, **dadurch gekennzeichnet, dass** die mathematische Analyse eine Mittelwertbildung der Messwerte innerhalb einer zeitlichen Reihe umfasst, wobei bei einem typischen vorbekannten Mittelwert eine Anmerkung angefügt wird, dass es sich um eine bestimmte Art von Netzknoten und/oder Messwert handelt.

4. Verfahren nach einem der Ansprüche 1 bis 2, **dadurch gekennzeichnet, dass** die mathematische Analyse eine Frequenzanalyse innerhalb einer zeitlichen Reihe umfasst, wobei bei Überschreitung eines typischen Zeitabstands zwischen zwei Messdatensätzen (M1) des Netzknotens (K1) eine Anmerkung angefügt wird, dass der Netzknoten (K1) ausgefallen ist.

5. Verfahren nach einem der Ansprüche 1 bis 2, **dadurch gekennzeichnet, dass** die mathematische Analyse eine Verhaltensanalyse innerhalb einer zeitlichen Reihe umfasst, wobei bei einer begrenzten Anzahl von immer gleichen Zahlenwerten als Messwerten des Netzknotens (K1) eine Anmerkung angefügt wird, dass es sich um einen Schalter oder Stufensteller handelt.

6. Verfahren nach einem der Ansprüche 1 bis 2, **dadurch gekennzeichnet, dass** die mathematische Analyse eine Korrelationsanalyse zwischen mehreren zeitlichen Reihen umfasst, wobei bei aufeinanderfolgenden Änderungen der Messwerte unterschiedlicher zeitlicher Reihen bzw. Netzknoten (K1) eine Anmerkung angefügt wird, dass es sich um elektrisch voneinander abhängige Netzknoten handelt.

7. Verfahren nach Anspruch 6, **dadurch gekennzeichnet, dass** für jenen Netzknoten (K1), der die erste Änderung erfährt, eine Anmerkung (T1) erstellt wird, dass es sich um einen Stufensteller handelt, während für die Netzknoten mit späteren Änderungen eine Anmerkung erstellt wird, dass diese als Messgeräte ausgebildet sind.

8. Verfahren nach einem der Ansprüche 1 bis 2, **dadurch gekennzeichnet, dass** die mathematische Analyse eine Ausfallsanalyse von mehreren zeitlichen Reihen umfasst, wobei bei gleichzeitigem Ausfall von mehreren Netzknoten (K1) eine Anmerkung erstellt wird, dass Abtrennungsschalter für diese Netzknoten vorhanden sind.

9. Verfahren nach einem der Ansprüche 1 bis 8, **dadurch gekennzeichnet, dass** Anmerkungen (T1, T2) mit einer Konfidenz oder einem Konfidenzintervall versehen werden.

10. Verfahren nach einem der Ansprüche 1 bis 9, **dadurch gekennzeichnet, dass** bei manueller Festlegung einer Konfidenz oder eines Konfidenzintervalls für eine Anmerkung (T1, T2) betreffend einen Netzknoten (K1) die Konfidenz oder das Konfidenzintervall von automatisch erstellten Anmerkungen betreffend andere Netzknoten erhöht wird.

11. Computerprogrammprodukt, welches ein Programm umfasst und direkt in einen Speicher eines zentralen Rechners eines Niederspannungsnetzes ladbar ist, mit Programm-Mitteln, um alle Schritte des Verfahrens nach einem der Ansprüche 1 bis 10 auszuführen, wenn das Programm vom zentralen Rechner ausgeführt wird.

## Claims

1. Method for data enrichment of measurement data records (M1) of a low-voltage network with at least one network node (K1) for representing the low-voltage network in a control room and/or for representing relationships between network nodes in the low-voltage network, wherein a measurement data record (M1) is generated by at least one network node (K1) and sent to a higher-level system (HE), in particular a head-end system, and this measurement data record (M1) contains at least one measured value and an item of structureless information which specifies the network node (K1) from which the data record originates, wherein, in particular asynchronously arriving measurement data records (M1), which are sent from a plurality of network nodes (K1) to the higher-level system (HE), are stored in a data memory (DS) in a time sequence for each network node (K1) in each case, **characterised in that**
- the time sequences are subjected to a mathematical analysis by means of automatic data processing by a device for automated data enriching (AE) of a mathematical analysis, wherein the mathematical analysis comprises a pattern recognition within a time sequence, and
- the result of the analysis is appended to the respective measurement data record (M1) in the form of at least one semantic comment (T1, T2), wherein if a pattern of the time sequence of the network node (K1) under investigation coincides with already known patterns that correspond to a known type of network node, the comment (T1, T2) is generated with an item of information in order to identify a physical entity of the network node (K1) under investigation.

2. Method according to claim 1, **characterised in that** a comment contains an item of information (T2) indicating which measurement variable is concerned in the measured value.

3. Method according to one of claims 1 to 2, **characterised in that** the mathematical analysis comprises an averaging of the measured values within a time sequence, wherein in the case of a typical already known average value, a comment is appended to the effect that a particular type of network node and/or measured value is under consideration.

4. Method according to one of claims 1 to 2, **characterised in that** the mathematical analysis comprises a frequency analysis within a time sequence, wherein if a typical time interval between two measurement data records (M1) of the network node (K1) is exceeded, a comment is appended to the effect that the network node (K1) has crashed.

5. Method according to one of claims 1 to 2, **characterised in that** the mathematical analysis comprises a behavioural analysis within a time sequence, wherein if a limited number of consistently identical numerical values are received as measured values of the network node (K1), a comment is appended to the effect that the network node is a switch or tap changer.

6. Method according to one of claims 1 to 2, **characterised in that** the mathematical analysis comprises a correlation analysis between a plurality of time sequences, wherein in the event of successive changes to the measured values of different time sequences or network nodes (K1), a comment is appended to the effect that the network nodes are electrically dependent on one another.

7. Method according to claim 6, **characterised in that** for that network node (K1) that experiences the first change, a comment (T1) is generated to the effect that it is a tap changer, whereas for the network nodes experiencing later changes, a comment is generated to the effect that these are embodied as measuring instruments.

8. Method according to one of claims 1 to 2, **characterised in that** the mathematical analysis comprises a failure analysis of a plurality of time sequences, wherein in the event of simultaneous failure of a plurality of network nodes (K1), a comment is generated to the effect that disconnection switches are present for said network nodes.

9. Method according to one of claims 1 to 8, **characterised in that** comments (T1, T2) are provided with a confidence or a confidence interval.

10. Method according to one of claims 1 to 9, **characterised in that** in the event of manual specification of a confidence or a confidence interval for a comment (T1, T2) relating to a network node (K1), the confidence or the confidence interval of automatically generated comments relating to other network nodes is increased.

11. Computer program product which comprises a program and can be loaded directly into a memory of a central computer of a low-voltage network and which has program means for carrying out all steps of the method according to one of claims 1 to 10 when the program is executed by the central computer.

## Revendications

1. Procédé destiné à l'enrichissement de données de jeux de données de mesure (M1) d'un réseau basse tension comportant au moins un nœud de réseau (K1) pour une représentation du réseau basse tension dans une salle de contrôle et/ou pour une représentation de relations de nœuds de réseau dans le réseau basse tension, dans lequel un jeu de données de mesure (M1) est généré par au moins un nœud de réseau (K1) et est envoyé à un système supérieur (HE), en particulier un système de tête de réseau, et ce jeu de données de mesure (M1) contient au moins une valeur de mesure et une information non structurée qui indique de quel nœud de réseau (K1) le jeu de données provient, dans lequel des jeux de données de mesure entrants (M1), entrant en particulier de manière asynchrone, qui sont envoyés au système supérieur (HE) par plusieurs nœuds de réseau (K1), sont mis en mémoire dans une mémoire de données (DS) dans respectivement une séquence temporelle par nœud de réseau (K1), **caractérisé en ce**
- **que** les séquences temporelles sont soumises à une analyse mathématique au moyen d'un traitement automatique de données par le biais d'un dispositif destiné à l'enrichissement de données automatisé (AE), dans lequel l'analyse mathématique comprend une reconnaissance de modèles au sein d'une séquence temporelle, et
- en ce qu'un résultat de l'analyse est ajouté au jeu de données de mesure (M1) respectif sous la forme d'au moins une annotation sémantique (T1, T2), dans lequel lors d'une concordance d'un modèle de la séquence temporelle du nœud de réseau (K1) étudié avec des modèles déjà connus, qui correspondent à un type connu de nœuds de réseau, l'annotation (T1, T2) est générée avec une information destinée à la détection d'une unité physique du nœud de réseau (K1) étudié.

2. Procédé selon la revendication 1, **caractérisé en ce qu'**une annotation contient une information (T2) qui indique de quelle grandeur de mesure il s'agit dans le cas de la valeur de mesure.

3. Procédé selon l'une des revendications 1 à 2, **caractérisé en ce que** l'analyse mathématique comprend la formation d'une valeur moyenne des valeurs de mesure au sein d'une séquence temporelle, dans lequel dans le cas d'une valeur moyenne déjà connue typique une annotation est ajoutée, qui indique qu'il s'agit d'un type déterminé de nœuds de réseau et/ou de valeur de mesure.

4. Procédé selon l'une des revendications 1 à 2, **caractérisé en ce que** l'analyse mathématique comprend une analyse de fréquence au sein d'une séquence temporelle, dans lequel lors du dépassement d'un écart de temps typique entre deux jeux de données de mesure (M1) du nœud de réseau (K1) une annotation est ajoutée, qui indique que le nœud de réseau (K1) est défaillant.

5. Procédé selon l'une des revendications 1 à 2, **caractérisé en ce que** l'analyse mathématique comprend une analyse de comportements au sein d'une séquence temporelle, dans lequel dans le cas d'un nombre limité de valeurs numériques toujours égales en tant que valeurs de mesure du nœud de réseau (K1) une annotation est ajoutée, qui indique qu'il s'agit d'un interrupteur ou d'un commutateur à prises de réglage.

6. Procédé selon l'une des revendications 1 à 2, **caractérisé en ce que** l'analyse mathématique comprend une analyse de corrélations entre plusieurs séquences temporelles, dans lequel en cas de modifications successives des données de mesure de séquences temporelles différentes resp. de nœuds de réseau (K1) différents une annotation est ajoutée, qui indique qu'il s'agit de nœuds de réseau électriquement dépendants les uns des autres.

7. Procédé selon la revendication 6, **caractérisé en ce que** pour chaque nœud de réseau (K1) qui expérimente la première modification une annotation (T1) est générée, qui indique qu'il s'agit d'un commutateur à prises de réglage tandis que pour les nœuds de réseau comportant des modifications tardives une annotation est générée, qui indique que ceux-ci sont configurés en tant qu'appareils de mesure.

8. Procédé selon l'une des revendications 1 à 2, **caractérisé en ce que** l'analyse mathématique comprend une analyse de défaillances de plusieurs séquences temporelles, dans lequel lors d'une défaillance simultanée de plusieurs nœuds (K1) une annotation est générée, qui indique que des disjoncteurs sont présents pour ces nœuds de réseau.

9. Procédé selon l'une des revendications 1 à 8, **caractérisé en ce que** des annotations (T1, T2) sont pourvues d'une confiance ou d'un intervalle de confiance.

10. Procédé selon l'une des revendications 1 à 9, **caractérisé en ce que,** en cas de spécification manuelle d'une confiance ou d'un intervalle de confiance pour une annotation (T1, T2) concernant un nœud de réseau (K1) la confiance ou l'intervalle de confiance sont augmentés par des annotations générées automatiquement concernant d'autres nœuds de réseau.

11. Produit de programme informatique, lequel comprend un programme et peut être chargé directement dans une mémoire d'un ordinateur central d'un réseau basse tension, comportant des moyens de programme pour exécuter toutes les étapes du procédé selon l'une des revendications 1 à 10 lorsque le programme est exécuté par un ordinateur central.
